# EUROPEAN PATENT APPLICATION

(11) **EP 4 553 857 A1**
(43) Date of publication of application: **14.05.2025**
(21) Application number: 23835130.8
(22) Date of filing: 24.04.2023
(51) Int. Cl.: H01B 1/22, C08K 3/01, C08L 101/00, H01B 1/00, H01B 5/14, H05K 1/02, H05K 1/09

(54) **ELECTROCONDUCTIVE PASTE, ELECTRIC CIRCUIT, FLEXIBLE ELECTRIC CIRCUIT OBJECT, AND METHOD FOR PRODUCING MOLDED OBJECT**

(30) Priority: 08.07.2022 JP 2022110482
(71) Applicant: Namics Corporation, Niigata-shi, Niigata 950-3131 (JP)
(72) Inventor: YONEDA, Takashi, Niigata-shi, Niigata 950-3131 (JP); OTOMO, Masayoshi, Niigata-shi, Niigata 950-3131 (JP)
(74) Representative: Hoffmann Eitle
(86) International application number: PCT/JP2023/016035
(87) International publication number: WO 2024/009589

(57) **Abstract**

Provided is a conductive paste capable of forming an electric wiring having a low possibility of breaking even when the electric wiring of an electric circuit and/or an electronic circuit is stretched and/or bent.

A conductive paste for forming a flexible electric circuit for forming an electric circuit on a surface of a flexible base material, comprising: conductive particles (A); a thermoplastic resin (B); and a solvent (C), wherein a temperature Tm (degree C) for measuring storage elastic modulus of the conductive paste is Tm = 178 degree C; and the storage elastic modulus at the temperature Tm of a cured product, in which the conductive paste is cured with a condition of 120 degree C for 30 minutes, is 0.001 to 0.5 GPa.

## Description

### FIELD OF THE INVENTION

The present invention relates to a conductive paste for forming an electrode and a wiring of an electric circuit and an electronic circuit. The present invention relates to an electric circuit and a flexible electric circuit body including a cured product of the conductive paste.

### BACKGROUND ART

In recent years, a conductive paste for forming an electrode and a wiring on a base material capable of stretching and bending has been developed. In addition, the formation of an electrode and a wiring of an electric circuit and an electronic circuit capable of heat molding has been tried using a conductive paste.

Patent Document 1 discloses a multilayer film adapted for use as a substrate for a printed circuit. Patent Document 1 describes that the multilayer film further comprises an electroconductive ink printed on a substrate, and suitable inks include Ag, Carbon, Cu, CNT, graphene, PEDOT, AgNW, and the like.

### Prior Art Documents

### Patent Documents

Patent document 1: JP 2020-523232 A

### DISCLOSURE OF THE INVENTION

In recent years, attempts have been made to form an electrode and a wiring, etc. of an electric and/or an electronic circuit (these may be collectively referred to as an "electric circuit".) on a surface of a base material capable of being stretched and/or bent. In addition, an attempt has been made to form an electric wiring such as an electric circuit by molding using a conductive paste. The technology to form an electric wiring by molding using a conductive paste is called "In-Mold Electronics (IME)". At the time of three dimensional molding such as heat molding, pressure molding and vacuum molding, the electric wiring is deformed by stretching and/or bending of the base material (for example, a flat sheet or a film), and there is a risk that the electric wiring of the electric circuit used for In-Mold Electronics breaks.

In addition, at the time of molding such as heat molding, pressure molding and vacuum molding, there are cases where three dimensional molding is performed to form various three dimensional shapes. In some shapes, since conductive fillers are included in the conductive paste during three dimensional molding, the extensibility of the conductive paste is poor. Therefore, it is difficult for an electric circuit pattern (a wiring pattern) of the conductive paste printed on a base material to expand following the expansion of the base material during three dimensional molding. Therefore, a stress cannot be relaxed, and there is a problem that cracks occur in the electric circuit pattern (the wiring pattern) during molding. There is a problem that the electric wiring breaks due to the occurrence of the cracks. The occurrence of cracks can be determined by observing the electric circuit pattern (the wiring pattern) with an optical microscope after the three dimensional molding.

Therefore, it is an object of the present invention to provide a conductive paste capable of forming an electric circuit and/or an electric wiring having a low possibility of breaking even when the electric wiring of the electric circuit and/or the electronic circuit is formed by using three dimensional molding.

In order to solve the above problem, embodiments of the present invention have the following configurations.

### (Configuration 1)

Configuration 1 is a conductive paste for forming a flexible electric circuit for forming an electric circuit on a surface of a flexible base material, comprising:
conductive particles (A);
a thermoplastic resin (B); and
a solvent (C),
wherein a temperature Tm (degree C) for measuring storage elastic modulus of the conductive paste is Tm = 178 degree C; and
the storage elastic modulus at the temperature Tm of a cured product, in which the conductive paste is cured with a condition of 120 degree C for 30 minutes, is 0.001 to 0.5 GPa.

### (Configuration 2)

Configuration 2 is the conductive paste of Configuration 1, wherein an absolute value of a difference between storage elastic modulus of the flexible base material at the temperature Tm and the storage elastic modulus at the temperature Tm of the cured product cured with the condition of 120 degree C for 30 minutes is 0 to 0.50 GPa.

### (Configuration 3)

Configuration 3 is the conductive paste of Configuration 1 or 2, wherein the thermoplastic resin (B) comprises at least one selected from a group consisting of polycarbonate resin, hydrogenated styrene-based thermoplastic elastomer, and styrene-butadiene-styrene block copolymer.

### (Configuration 4)

Configuration 4 is the conductive paste of Configuration 3, wherein the polycarbonate resin comprises at least one selected from poly (4, 4'-cyclohexylidenediphenyl) carbonate and copoly [2, 2-bis (4-hydroxyphenyl) propane/2, 2-bis (4-hydroxy-3-methylphenyl) propane] carbonate.

### (Configuration 5)

Configuration 5 is the conductive paste of any of Configurations 1 to 4, wherein the conductive particles (A) are silver particles.

### (Configuration 6)

Configuration 6 is the conductive paste of any of Configurations 1 to 5, wherein the conductive particles (A) are indefinite form or scale-like in shape.

### (Configuration 7)

Configuration 7 is the conductive paste of any of Configurations 1 to 6, wherein the flexible base material comprises at least one selected from a group consisting of polycarbonate, polyethylene terephthalate (PET) and acrylic resin.

### (Configuration 8)

Configuration 8 is an electric circuit comprising a cured product of the conductive paste of any of Configurations 1 to 7.

### (Configuration 9)

Configuration 9 is a flexible electric circuit body comprising the flexible base material and the electric circuit of Configuration 8 disposed on a surface of the flexible base material.

### (Configuration 10)

Configuration 10 is a method for producing a molded body comprising:
forming an electric circuit on a surface of the flexible base material using the conductive paste any of Configurations 1 to 7; and
forming the molded body by molding the flexible base material on which the electric circuit is formed.

According to present invention, even when the electric wiring of the electric circuit and/or the electronic circuit is formed by using three dimensional molding, a conductive paste capable of forming an electric wiring having a low possibility of breaking can be provided.

### BRIEF DESCRIPTION OF THE DRAWINGS

Fig. 1 is an optical microscope image (magnification: 20×) showing an example in which, after a cured product (a wiring pattern) of a conductive paste was subjected to three dimensional molding, cracks do not occur in the cured product.
Fig. 2 is an optical microscope image (magnification: 20×) showing an example in which, after a cured product (a wiring pattern) of a conductive paste was subjected to three dimensional molding, cracks occur in the cured product.
Fig. 3 is a schematic diagram showing a wiring pattern of a conductive paste (a printing pattern of a conductive paste) used to measure the specific resistance of a cured product of the conductive paste.
Fig. 4 is a photograph of an example shape after three dimensional molding of a flexible base material with a wiring pattern of Examples and Comparative Examples.
Fig. 5 is a schematic diagram showing a shape after three dimensional molding of a flexible base material with a wiring pattern of Examples and Comparative Examples.

### MODE FOR CARRYING OUT THE INVENTION

Hereinafter, embodiments of the present invention will be specifically described with reference to the drawings. The following embodiments are embodiments for embodying the present invention, and the present invention is not limited to the scope thereof.

The present embodiment is a conductive paste for forming a flexible electric circuit for forming an electric circuit on a surface of a flexible base material. The conductive paste of the present embodiment includes conductive particles (A), a thermoplastic resin (B), and a solvent (C). When the conductive paste of the present embodiment is cured under a predetermined condition to produce a cured product, the cured product has storage elastic modulus of 0.001 to 0.5 GPa at a predetermined temperature Tm (degree C). The temperature Tm (degree C) is a temperature for measuring the storage elastic modulus of the cured product of the conductive paste. The temperature Tm (degree C) may be 178 degree C. The predetermined condition for curing the conductive paste may be 120 degree C and 30 minutes.

By using the conductive paste of the present embodiment having the predetermined storage elastic modulus at the temperature Tm, it is possible to form an electric wiring having a low possibility of breaking even when the electric wiring of an electric circuit and/or the electronic circuit (these may be collectively referred to simply as an "electric circuit".) is stretched and/or bent by using three dimensional molding. More specifically, when an electric circuit, which is a cured product of the conductive paste of the present embodiment, is subjected to three dimensional molding, it is possible to suppress occurrence of cracks in an electric wiring included in the electric circuit.

In the present specification, a "flexible base material" means an object to be printed when the electric circuit pattern included in the electric circuit is printed using the conductive paste. The "electric circuit pattern" is sometimes referred to as a "wiring pattern". In the present specification, the flexible base material is also simply referred to as a "base material". Since the "flexible base material" is generally in a shape of a flat sheet or a film, the flexible base material is sometimes referred to as a "flat sheet" or a "film". A preferred embodiment of the flexible base material is a flat sheet made of polycarbonate resin, polyethylene terephthalate (PET) resin, and/or acrylic resin. The flexible base material is a base material that is flexible enough to deform, such as stretched and/or bent, at least when heated to a predetermined temperature. Thus, the flexible base material may not be flexible at room temperature (e.g., below 30 degree C). A predetermined temperature when heated is, for example, 140 to 220 degree C.

In the present specification, a "flexible electric circuit body" includes a flexible base material (a flat sheet or a film) and a cured product obtained by printing an electric circuit pattern (a wiring pattern) on a surface of the flexible base material using a conductive paste, and then heating and drying the printed conductive paste to cure. The flexible electric circuit body may be used for three dimensional molding. The flexible electric circuit body including the flexible base material is flexible when heated to at least a predetermined temperature. Therefore, the flexible electric circuit body may not be flexible at room temperature (e.g., below 30 degree C). Like the flexible base material, a predetermined temperature when heated is, for example, 140 to 220 degree C.

In the present specification, a term "molded body" refers to a flexible electric circuit body (a flat sheet or a film having an electric circuit pattern (a wiring pattern)) which is molded together with another resin (e.g., the flexible base material and a resin for molding, etc.) by three dimensional molding or injection molding. In the present specification, a term "molding" refers to a processing method for processing a material into a predetermined shape using a mold, such as heat molding, pressure molding, vacuum molding, and injection molding. In the present specification, a term "three dimensional molding" refers to a processing method for processing a flat sheet or a film with a two-dimensional like shape having an electric circuit pattern (a wiring pattern) into a three dimensional shape by molding using a mold, such as heat molding, pressure molding, and vacuum molding. A flexible electric circuit body subjected to three dimensional molding can be referred to as a "three-dimensional molded body".

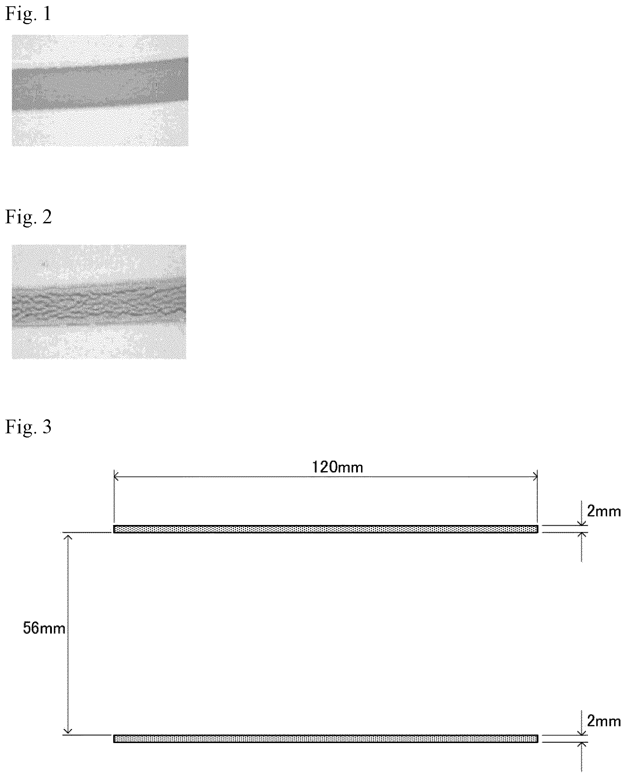

In present specification, the occurrence of "cracks" can be determined by observing a surface of a cured product (a wiring pattern) of the conductive paste using an optical microscope (magnification: 20×) after three dimensional molding. Fig. 1 shows an example of an optical microscope image (magnification: 20×) when no cracks occur in a cured product after three dimensional molding of the cured product (a wiring pattern) of a conductive paste. Fig. 2 shows an example of an optical microscope image (magnification: 20×) when cracks occurs in a cured product after three dimensional molding of the cured product (a wiring pattern) of a conductive paste. In the optical microscope image of the wiring pattern in Fig. 2, it can be seen that stripe pattern occurs. This stripe pattern is caused by the occurrence of the cracks. Therefore, it can be determined from the wiring pattern in Fig. 2 that cracks have occurred. In contrast, no stripe pattern was observed in the optical microscope image of the wiring pattern in Fig. 1. Therefore, it can be determined from the wiring pattern in Fig. 1 that cracks have not occurred.

The conductive paste of the present embodiment is preferably a conductive paste for In-Mold Electronics. In general, a technique of sticking a flat sheet or a film-shaped base material at the same time of molding is referred to as In-Mold. In addition, there is a technique called In-Mold Electronics which utilizes In-Mold. In general, In-Mold Electronics is a technique of integrating a base material with an electric circuit pattern on a surface of a molded body. Specifically, an electric circuit pattern (a flexible electric circuit body) such as a film-type electronic component such as a touch sensor or a film antenna is formed on a flat sheet or a film-shaped base material, and the base material with the electric circuit pattern is three-dimensionally molded as necessary, sandwiched between molds, and molded to integrate the base material with an electric circuit pattern on the surface of the molded body. By using the conductive paste of the present embodiment, an electric wiring having a low possibility of breaking can be formed even when the base material is stretched and/or bent. Therefore, the conductive paste of the embodiment can be preferably used as a conductive paste for in-mold electronics.

Next, the conductive paste of the present embodiment will be described.

Since the conductive paste of the present embodiment contains a predetermined components, an electric wiring having a low possibility of breaking can be formed even when the electrode and the wiring, etc. (also referred to as "electric wiring" or simply "wiring".) of the electric circuit and/or the electronic circuit (it is sometimes simply referred to as an "electric circuit".) are stretched and/or bent. Also, the conductive paste of the present embodiment can form an electric wiring having a low possibility of breaking even when the electric wiring is formed by using three dimensional molding.

### <Conductive particles (A)>

The conductive paste of the present embodiment contains conductive particles as the component (A).

In the present invention, conductive particles are particles having an average particle diameter of 0.01 to 100 µm and an electrical conductivity of 10⁶ S/m or more. The conductive particles may be particles of a conductive material, or core particles coated with a conductive material. The core particles may be made of a nonconductive material, so long as a part of the core particles is coated with a conductive material. Examples of conductive particles include metal powders and coated powders.

The conductive particles are used to impart thermal conductivity and/or conductivity to the cured product of the conductive paste of the present embodiment. The conductive materials are not particularly limited. Examples of such conductive materials include gold, silver, nickel, copper, palladium, platinum, bismuth, tin, alloys thereof (especially bismuth-tin alloy, solder, etc.), aluminum, indium tin oxide, silver-coated copper, silver-coated aluminum, metal-coated glass spheres, silver-coated fibers, silver-coated resins, antimony-doped tin, tin oxide, carbon fibers, graphite, carbon black, and mixtures thereof.

Considering thermal conductivity and conductivity, the conductive material component preferably includes at least one metal selected from a group consisting of silver, nickel, copper, tin, aluminum, silver alloys, nickel alloys, copper alloys, tin alloys, and aluminum alloys, more preferably at least one metal selected from a group consisting of silver, copper, and nickel, further more preferably silver or copper, and most preferably silver.

When the conductive particles include the predetermined metal, an electric wiring having low electrical resistance can be formed. The conductive particles can be particles coated with a conductive material such as the metal described above on the surface of the insulating particles.

The conductive particles included in the conductive paste of the present embodiment are preferably silver particles. The electrical conductivity of silver (Ag) is relatively high. Therefore, silver (Ag) particles (i.e., conductive particles consisting of silver) are preferably used as the conductive particles. By using silver particles as the conductive particles, an electric wiring with low electrical resistance can be formed.

More preferably, the conductive particles contained in the conductive paste of the present embodiment are conductive particles consisting of silver. In the present specification, for example, "conductive particles consisting of silver" means that components other than silver are not intentionally added, and unavoidably contained impurities are allowed to be contained in the conductive particles. The same applies to conductive particles consisting of metals other than silver and components other than the conductive particles.

The shape of the conductive particles is not particularly limited, but may be any of spherical, indefinite form, scale-like shape, filamentary (needle-like), dendritic, and the like. Here, the scale-like shape means a shape in which the ratio of "long diameter / short diameter" (aspect ratio) is 2 or more, and includes flat plates such as plates and scale-like shapes. The long diameter and short diameter of a particle constituting the conductive particles can be determined based on images obtained from a scanning electron microscope (SEM) (n = 20). The "long diameter" means a diameter having the longest distance among line segments passing through the approximate center of gravity of the particles in the particles image obtained by SEM, and the "short diameter" means a line segment having the shortest distance among line segments passing through the approximate center of gravity of the particles in the particles image obtained by SEM.

The shape of the conductive particles such as silver particles is preferably an indefinite form or a scale-like shape. When the shape of the conductive particles included in the conductive paste of the present embodiment is an indefinite form or a scale-like shape, an electric wiring having a low electrical resistance can be more stably formed. When the conductive particles are silver particles, the shape of the silver particles is preferably an indefinite form or a scale-like shape.

The shape of the particles may be a combination of particles having different shapes.

The particle size of the conductive particles can be defined by the particle size of an integrated value of 50% of all particles (D50). In the present specification, D50 is also referred to as the average particle diameter. The average particle diameter (D50) can be determined from the result of measurement of particle diameter distribution performed by the microtrack method (laser diffraction scattering method).

The average particle diameter (D50) of the conductive particles is preferably 0.1 to 30 µm, more preferably 0.2 to 20 µm, further more preferably 0.5 to 15 µm, and particularly preferably 0.8 to 10 µm in view of resistance to stretched and/or bent and workability. When the average particle diameter (D50) is larger than the above range, problems such as clogging may occur during screen printing. When the average particle diameter is smaller than the above range, the particles are excessively sintered during curing of the conductive paste, which may make it difficult to form an electric wiring having resistance to stretching and/or bending.

The specific surface area of the conductive particles can be expressed as a BET value (BET specific surface area). The BET value of the conductive particles is preferably 0.1 to 10 m²/g, more preferably 0.2 to 5 m²/g, and still more preferably 0.5 to 3 m²/g. The BET value can be measured by, for example, a gas adsorption method (BET method) according to JIS Z8830:2013 (ISO9277:2010).

If the specific surface area of the conductive particles is too large, the viscosity becomes high and capability the handing is reduced when the conductive particles are made into paste. On the other hand, if the specific surface area of the conductive particles is too small, the contact area between the conductive particles becomes small and the conductivity decreases.

### <Thermoplastic resin (B)>

The conductive paste of the present embodiment includes thermoplastic resin as component (B).

The thermoplastic resin included in the conductive paste of the present embodiment preferably includes thermoplastic resin such that storage elastic modulus at the temperature Tm of a cured product obtained by heating and drying the conductive paste including the thermoplastic resin at 120 degree C for 30 minutes is 0.001 to 0.5 GPa. The temperature Tm may be 178 degree C. By including such thermoplastic resin in the conductive paste of the present embodiment, when the cured product of the conductive paste as an electric wiring is subjected to three dimensional molding, it becomes possible to form an electric wiring having low possibility of breaking.

The glass transition temperature of the thermoplastic resin included in the conductive paste of the present embodiment is 100 to 200 degree C, preferably 120 to 200 degree C, and more preferably 120 to 190 degree C. The glass transition temperature of the thermoplastic resin can be measured by differential scanning calorimetry (DSC). In In-Mold Electronics, the general temperature for heat molding is 140 degree C to 220 degree C, the temperature for pressure molding is 140 degree C to 160 degree C, and the temperature for vacuum molding is 160 to 220 degree C. When a resin component having a glass transition temperature within the above range is used as the resin component of the conductive paste, the flat sheet (film) and the cured product of the conductive paste can follow well during three dimensional molding using heat molding or the like. Therefore, even if the electric circuit pattern is deformed during three dimensional molding, the possibility of breaking of an electric wiring can be reduced. When the glass transition temperature is within the above range, the occurrence of cracks in the cured product obtained can be suppressed, so that the resistance value is lower and the cured product can be used as a wiring.

In the conductive paste of the present embodiment, the thermoplastic resin (B) preferably contains at least one selected from a group consisting of polycarbonate resin, hydrogenated styrene-based thermoplastic elastomer, and styrene-butadiene-styrene block copolymer. By using these materials as the thermoplastic resin (B), the possibility of breaking of an electric wiring can be further reduced.

The conductive paste of the present embodiment preferably contains polycarbonate resin. The thermoplastic resin is more preferably consisting of polycarbonate resin.

When three dimensional molding, a molded body having an electric wiring can be produced by printing a predetermined electric wiring on a flat sheet (film) of polycarbonate resin and using the flat sheet for three dimensional molding. Since the thermoplastic resin contains polycarbonate resin, the electric wiring can follow the deformation of the flat sheet well during three dimensional molding. Therefore, the possibility of breaking of the electric wiring can be reduced.

In the conductive paste of the present embodiment, it is preferable that the polycarbonate resin contains at least one selected from poly (4, 4'-cyclohexylidenediphenyl) carbonate and copoly [2, 2-bis (4-hydroxyphenyl) propane/2, 2-bis (4-hydroxy-3-methylphenyl) propane] carbonate. Since the polycarbonate resin is one of these materials, the possibility of breaking of an electric wiring can be further reduced.

As the thermoplastic resin, two or more different thermoplastic resins can be used. For example, two or more different polycarbonate resins can be used as the thermoplastic resin. Also, two or more different resins other than the polycarbonate resin can be used as the thermoplastic resin. As two or more different resins, polycarbonate resin and resins other than polycarbonate resin can be used in combination.

Furthermore, thermoplastic resin is generally produced using raw materials derived from petroleum resources. However, in recent years, the depletion of petroleum resources has been concerned, and thermoplastic resin using raw materials obtained from biomass resources such as plants has been developed. Furthermore, since global warming caused by the increase and accumulation of carbon dioxide emissions is concerned to bring climate change, it is also possible to use thermoplastic resin derived from plants that is carbon neutral even after disposal after use.

The thermoplastic resin contained in the conductive paste of the present embodiment can be a hydrogenated styrenic thermoplastic elastomer or a styrene-ethylene-butylene-styrene (SEBS) block copolymer. Examples of commercially available SEBS lock copolymers of hydrogenated styrenic thermoplastic elastomers that can be used in the conductive paste of the present embodiment include Tuftec H1041, H1043, H1051 and M1913 manufactured by Asahi Kasei Corporation and Septon 4077 and Septon 4099 manufactured by Kuraray Co., Ltd. If the resin has a low elastic modulus such that the storage elastic modulus of the cured product of the conductive paste is 0.001 to 0.5 GPa, it can have a structure such as a styrene-butadiene-styrene (SBS) block copolymer or a styrene-ethylene-ethylene-propylene-styrene (SEEPS) block copolymer. Examples of commercially available SBS block copolymers include Tufpuren (registered trademark) A manufactured by Asahi Kasei Corporation. SEPTON 4033 manufactured by Kuraray Co., Ltd. can be a commercial product of the SEEPS block copolymer.

The inventors of the present invention found that when a cured product of the conductive paste is cured under the predetermined condition and the storage elastic modulus measured at the predetermined temperature Tm for measuring the storage elastic modulus is 0.001 to 0.5 GPa, the occurrence of cracks in the cured product (the electric circuit pattern) of the conductive paste arranged in the molded body subjected to three dimensional molding can be suppressed, and the possibility of breaking of the electric wiring can be reduced. By appropriately controlling the type and the amount of thermoplastic resin contained in the conductive paste, the storage elastic modulus of the predetermined cured product of the conductive paste can be controlled within the appropriate range. For example, the storage elastic modulus at the temperature Tm (degree C) for measuring the storage elastic modulus can be controlled by increasing the molecular weight, adjusting the ratio of hard segments having a rigid structure in the thermoplastic resin, and/or adjusting the ratio of soft segments having a flexible structure in the thermoplastic resin. As the thermoplastic resin, at least one kind selected from polycarbonate-based resins, polystyrene-based resins, polyolefin-based resins, polyvinylchloride-based resins, polyurethane-based resins, polyester-based resins, polyamide-based resins, polybutadiene-based resins, hydrides thereof, and modified copolymer hydrides obtained by modifying these hydrides may be used, and two or more kinds may be used in combination. Since the storage elastic modulus tends to be lowered by increasing the thermoplastic resin content, the storage elastic modulus can be adjusted by adjusting the content of the thermoplastic resin. As described later, the predetermined conditions for curing the cured product of the conductive paste are conditions of 120 degree C and 30 minutes. The temperature Tm (degree C) for measuring the storage elastic modulus of the cured product of the conductive paste can be Tm = 178 degree C.

The viscosity average molecular weight of the thermoplastic resin (for example, polycarbonate resin) contained in the conductive paste of the present embodiment is preferably 10,000 to 100,000, more preferably 10,000 to 80,000, and further more preferably 10,000 to 60,000. When the molecular weight of the thermoplastic resin is high, it may be necessary to increase the amount of solvent to obtain a predetermined viscosity. When the amount of solvent is large, the film thickness of the coating film becomes thin. When the molecular weight of the thermoplastic resin (for example, polycarbonate resin) is in the above range, the viscosity, the elongation property during heating, and the electrical resistance value of the cured product can be appropriately balanced.

When polycarbonate is used as the thermoplastic resin, some types of polycarbonate resin have high crystallinity. There has been a problem that a highly crystalline polycarbonate resin crystallizes when it is returned to room temperature after being dissolved in solvent by heating. It is not easy to use such a polycarbonate resin as a resin component of conductive paste. On the other hand, the predetermined polycarbonate resin described above can dissolve in a predetermined solvent, such as isophorone having a high boiling point, and the problem of crystallization after returning to room temperature can be avoided. Therefore, the possibility of breaking of an electric wiring can be lower by using the polycarbonate resin described above as the thermoplastic resin.

In the conductive paste of the present embodiment, an electric circuit pattern can be easily printed on a surface of a flexible base material made of polycarbonate resin. In addition, an electric circuit pattern can be easily printed on a surface of a base material made of a material other than polycarbonate resin.

In the conductive paste of the present embodiment, the blending amount of thermoplastic resin (B) is preferably 1 to 50 parts by weight, more preferably 5 to 45 parts by weight, further more preferably 8 to 43 parts by weight, and particularly preferably 10 to 40 parts by weight, with the conductive particles (A) being 100 parts by weight. By setting the weight ratio of conductive particles to thermoplastic resin (B) in the appropriate range, the shape of the print pattern of the electric wiring can be kept appropriate, and the electrical resistance of the electric wiring can be lowered.

The conductive paste of the present embodiment can include other resins, such as thermoplastic resin, thermosetting resin and/or photocuring resin, to the extent that they do not interfere with the effect.

### <Solvent (C)>

The conductive paste of the present embodiment contains solvent as component (C).

The conductive paste of the present embodiment preferably has a solvent with a boiling point of 150 degree C or more and 300 degree C or less. Polycarbonate resin can be dissolved by using a solvent having a high boiling point, for example, a solvent such as isophorone. Further, a hydrogenated styrene-based thermoplastic elastomer resin can be dissolved by using a solvent such as diethylene glycol dibutyl ether. In addition, since the boiling point of the solvent is not less than the predetermined temperature, after screen printing of the electric circuit pattern using the conductive paste, the drying time can be an appropriate length without extremely shortening the drying time, which improves the workability. Therefore, the electric circuit pattern can be deformed following the deformation of the flat sheet or the film during three dimensional molding more easily. When the boiling point of the solvent exceeds 300 degree C, the solvent may not be sufficiently removed during drying and heating for molding.

Specifically, the solvent preferably contains at least one selected from isophorone, 3 methoxy N, N dimethylpropanamide, benzyl alcohol, butyl carbitol (diethylene glycol monobutyl ether), diethylene glycol dibutyl ether, ethyl carbitol acetate (diethylene glycol monoethyl ether acetate), and tetraglyme. Polycarbonate resin and hydrogenated styrene-based thermoplastic elastomer resin can be surely dissolved by these predetermined solvents. Further, when the conductive paste contains the predetermined solvent, the possibility of breaking of the obtained electric wiring can be further reduced. In particular, when poly (4, 4'-cyclohexylidenediphenyl) carbonate and/or copoly [2, 2-bis (4-hydroxyphenyl) propane/2, 2-bis (4-hydroxy-3-methylphenyl) propane] carbonate is dissolved in the solvent as the thermoplastic resin, the solvent described above can be preferably used. Therefore, the conductive paste can be easily made into a paste, and the possibility of breaking of the obtained electric wiring can be further reduced.

The solvent preferably contains isophorone. By using isophorone as the solvent, the polycarbonate resin can be more easily dissolved in the solvent. Since the boiling point of isophorone is 215 degree C, it can be said that the boiling point of the solvent is suitable for printing the conductive paste. Further, the conductive paste containing the solvent of isophorone has advantages such as that it is difficult to gel or solidify even when the conductive paste is placed and left, and that solid-liquid separation does not occur during printing. Therefore, it is preferable that the solvent contains isophorone. Particularly, when poly (4, 4'-cyclohexylidenediphenyl) carbonate and/or copoly [2, 2-bis (4-hydroxyphenyl) propane/2, 2-bis (4-hydroxy-3-methylphenyl) propane] carbonate are dissolved in the solvent as the thermoplastic resin, the solvent containing isophorone can be preferably used.

The solvent preferably contains diethylene glycol dibutyl ether. By using diethylene glycol dibutyl ether as the solvent, the hydrogenated styrene-based thermoplastic elastomer resin (e.g., maleic acid-modified styrene-butadiene elastomers) can be more easily dissolved in the solvent. Since the boiling point of diethylene glycol dibutyl ether is 255 degree C, it can be said that the boiling point of the solvent is suitable for printing the conductive paste. Further, the conductive paste containing the solvent of diethylene glycol dibutyl ether has advantages such as that it is difficult to gel or solidify even when the conductive paste is placed and left, and that solid/liquid separation does not occur during printing. Therefore, the solvent preferably contains diethylene glycol dibutyl ether, and more preferably the solvent consists of diethylene glycol dibutyl ether only. In particular, when maleic acid modified styrene-butadiene elastomer resin is dissolved in the solvent as the thermoplastic resin, the solvent containing diethylene glycol dibutyl ether can be preferably used.

The amount of solvent added is preferably 50 to 1000 parts by weight, more preferably 80 to 900 parts by weight, further more preferably 100 to 800 parts by weight, and particularly preferably 100 to 500 parts by weight, relative to 100 parts by weight of the thermoplastic resin. Generally, the thermoplastic resin can be properly dissolved by using solvent having a weight of about four times the weight of the thermoplastic resin.

The solvent can be additionally added to the conductive paste as needed to adjust the viscosity of the conductive paste.

### <Other components>

The conductive paste of the present invention may include at least one selected from inorganic pigments, organic pigments, silane coupling agents, leveling agents, thixotropic agents, insulating particles, surface treating agents such as coupling agents, pigments, dyes, plasticizers, antifoaming agents, foaming breakers, antioxidants, leveling agents, thixotropic agents, and the like, to the extent that does not interfere with the effect of the present invention or to enhance the effect of the present invention.

### <Conductive paste>

The present embodiment is a conductive paste containing the above-mentioned components.

The conductive paste of the present embodiment may be a conductive paste consisting solely of components including the conductive particles (A), thermoplastic resin (B) and solvent (C) described above. However, to the extent that it does not interfere with the effect of the present invention or to enhance the effect of the present invention, the conductive paste of the present embodiment may include other components other than the components (A) to (C) described above. That is, the conductive paste of the present embodiment may further include at least one selected from inorganic pigments, organic pigments, silane coupling agents, leveling agents, thixotropic agents, insulating particles, surfactants such as coupling agents, pigments, dyes, plasticizers, antifoaming agents, foam breakers, antioxidants, leveling agents, thixotropic agents, and the like.

The conductive paste of the present embodiment may be prepared by placing and mixing the components described above (the conductive particles (A), the thermoplastic resin (B) and the solvent (C)) and optionally other components added in a mixer such as a planetary stirring machine, a dissolver, a bead mill, a grinding kneader, a three-roll mill, a rotary mixer, or a twin-screw mixer, and mixing the components. The conductive paste may thus be prepared to be suitable for screen printing, dipping, or any other desired method of forming a coating film or electric wiring.

The viscosity of the conductive paste of the present embodiment may be adjusted to a viscosity suitable for a given method of forming a coating film or an electric wiring, such as screen printing. The viscosity may be adjusted by appropriately controlling the amount of solvent.

The viscosity of the conductive paste of the present embodiment is preferably 1 to 1000 Pa·sec, more preferably 2 to 700 Pa·sec, further more preferably 5 to 600 Pa·sec, and particularly preferably 7 to 300 Pa·sec. The viscosity can be measured by a viscometer (B-type) manufactured by Brookfield Corporation using an SC4-14 spindle (Utility Cup and Spindle (UC/S) = #14) at a speed of 10 rpm and a measuring temperature of 25 degrees C.

By using the conductive paste of the present embodiment, it is possible to form a wiring of an electric circuit having a low possibility of breaking on a surface of a flexible base material by known coating methods (dip coating, spray coating, bar coater coating, gravure coating, reverse gravure coating, spin coater coating, etc.), known printing methods (lithographic printing, carton printing, metal printing, offset printing, screen printing, gravure printing, flexographic printing, inkjet printing, etc.), a jet dispenser, an air dispenser, or the like.

### <Flexible base material>

In In-Mold Electronics, a flexible base material (a flat sheet or a film) on which an electric circuit pattern is printed using a conductive paste is used for three dimensional molding. The material of the base material is not particularly limited as long as the base material is capable of three dimensional molding. The flexible base material preferably includes a base material made of polycarbonate resin, polyethylene terephthalate (PET), and acrylic resin. In particular, by setting the material of the flexible base material (the flat sheet or the film) and the glass transition temperature and the softening temperature of the resin component in the conductive paste to the same level, the elongation of the flat sheet or the film during three dimensional molding using heat molding, pressure molding, vacuum molding, or the like can appropriately follow the elongation of the resin component in the conductive paste. Therefore, the possibility of breaking of an electric wiring can be made lower.

### <Electric circuit including cured product of conductive paste>

The present embodiment is an electric circuit including a cured product of the predetermined conductive paste. In the present specification, a product obtained by printing the conductive paste of the present embodiment into a predetermined pattern and heating and drying it under a predetermined heating and drying condition (e.g., 120 degree C, 30 minutes) is referred to as a "cured product". The cured product can be used as an electric wiring of an electric circuit or the like. Therefore, an electric circuit with a low possibility of breaking can be formed by the conductive paste of the present embodiment. The heating of the conductive paste in producing the cured product does not have to be the final heating.

For the conductive paste of the present embodiment, a storage elastic modulus measured at the predetermined temperature Tm for measuring the storage elastic modulus of a cured product, in which the conductive paste is cured with the predetermined condition, is 0.001 to 0.5 GPa. The predetermined condition for curing the cured product of the conductive paste in the present embodiment is 120 degree C and 30 minutes. The conductive paste can be cured in an air atmosphere. The temperature Tm (degree C) for measuring the storage elastic modulus of the conductive paste can be Tm = 178 degree C.

The inventors of the present invention found that when the storage elastic modulus of the cured product (the electric circuit pattern) is 0.001 to 0.5 GPa at 178 degree C, which is close to the temperature at the time of three dimensional molding using a flexible base material, the occurrence of cracks in the cured product (the electric circuit pattern) of the conductive paste arranged in the molded body can be suppressed, and the possibility of breaking of the electric wiring can be reduced.

As the method of three dimensional molding, for example, methods such as heat molding, pressure molding and vacuum molding can be mentioned. The molding temperature may be different depending on the method of three dimensional molding. The molding temperature may be different depending on the type of flexible base material. Therefore, strictly speaking, the temperature Tm (degree C) for measuring the storage elastic modulus must be appropriately selected depending on the molding method and the type of the flexible base material. However, it is complicated to select an appropriate temperature depending on the molding method and the type of the flexible base material. On the other hand, inventors of the present invention found that when the storage elastic modulus is measured by setting the temperature Tm (degree C) to 178 degree C, and the storage elastic modulus of the cured product of the conductive paste is 0.001 to 0.5 GPa, the occurrence of cracks in the cured product of the conductive paste can be suppressed, and the possibility of breaking of the electric wiring can be reduced. This suggests that although the molding temperature differs depending on the molding method and the type of the flexible base material, the occurrence of cracks in the cured product of the conductive paste can be suppressed by selecting an appropriate representative temperature Tm (degree C).

It is also possible to select a temperature other than 178 degree C as the temperature Tm (degree C). For example, as the temperature Tm (degree C), the glass transition temperature of the material of the flexible base material can be set as Tg (degree C), and the temperature in the range from Tg to Tg + 60 degree C can be set as the temperature Tm (degree C) for measuring the storage elastic modulus of the cured product. On the other hand, it is complicated to determine which temperature among the temperatures in the range from Tg to Tg + 60 degree C should be selected as Tm (degree C). Therefore, it is preferable to use 178 degree C as the temperature Tm (degree C). The inventors of the present invention found that by using 178 degree C as an appropriate representative temperature Tm (degree C), it is possible to suppress the occurrence of cracks in the cured product of the conductive paste during the three dimensional molding. Considering the type of the molding method and the type of the flexible base material, when 178 degree C is selected as the temperature Tm (degree C), since the storage elastic modulus is 0.001 to 0.5 GPa, the occurrence of cracks in the cured product (electric circuit pattern) of the conductive paste arranged in the molded body can be suppressed, and the possibility of breaking of an electric wiring can be reduced. In particular, when a flat sheet or a film using polycarbonate resin as a material is used as the flexible base material, it is preferable that the temperature Tm (degree C) is Tm = 178 degree C.

As described above, when the cured product of the conductive paste of the present embodiment is cured under the predetermined condition and the storage elastic modulus of the cured product measured at the predetermined temperature Tm for measuring the storage elastic modulus is 0.001 to 0.5 GPa, it is possible to suppress the occurrence of cracks in the cured product (the electric circuit pattern) of the conductive paste during three dimensional molding. The reasons for this are as follows. When the temperature is increased from the room temperature to the molding temperature (e.g., 140 to 220 degree C), the storage elastic modulus of the general flexible base material (for example, a flat sheet or a film made of polycarbonate resin) used for three dimensional molding rapidly decreases from near the molding temperature (e.g., about 140 degree C). When the storage elastic modulus of the flexible base material at the molding temperature is close to the storage elastic modulus of the cured product (the electric circuit pattern) of the conductive paste, the deformation of the cured product of the flexible base material and the conductive paste becomes similar, and it is considered that the occurrence of cracks in the cured product can be suppressed. However, present invention is not restricted by this reasoning.

In present specification, a result of printing an electric circuit pattern on a surface of a flexible base material (for example, a flat sheet or a film made of polycarbonate resin) and forming a cured product (an electric circuit) by curing the printed conductive paste may be referred to a flexible electric circuit body. The flexible electric circuit body of the present embodiment preferably includes a flexible base material and an electric circuit arranged on the flexible base material.

The conductive paste of the present embodiment can preferably be used as a conductive paste for forming the flexible electric circuit body. The flexible electric circuit body of the present embodiment can be used for three dimensional molding to produce a molded body containing a desired electric circuit.

The flexible base material on which the conductive paste of the present embodiment is printed preferably includes at least one selected from a group consisting of polycarbonate, polyethylene terephthalate (PET), and acrylic resin. By using the predetermined flexible base material, the electric wiring of the electric circuit can be formed in the molded body with a low probability of breaking even when the electric wiring of the electric circuit and/or the electronic circuit is stretched and/or bent.

To form a flexible electric circuit body, an electric circuit pattern is first printed on a surface of the flexible base material using the conductive paste of the present embodiment, and then cured by heating and drying the electric circuit pattern of the conductive paste. The temperature and time for curing the electric circuit pattern of the conductive paste can be suitably selected depending on a kind of thermoplastic resin contained in the conductive paste. The temperature and the time for curing the conductive paste can be appropriately adjusted and determined in consideration of the heat resistance of the base material. For example, the temperature and the time for curing the conductive paste may be from 3 minutes to 60 minutes at 60 degree C to 160 degree C, preferably from 3 minutes to 60 minutes at 80 degree C to 150 degree C, more preferably from 3 minutes to 30 minutes at 100 degree C to 130 degree C. The cured product of the electric circuit pattern can be obtained by curing the electric circuit pattern at the predetermined temperature and time. Specific example of a curing condition is the condition of 120 degree C and 30 minutes.

In the conductive paste of the present embodiment, it is preferable that an absolute value of the difference between storage elastic modulus at the temperature Tm of the flexible base material and the storage elastic modulus at the temperature Tm of the cured product obtained by curing the conductive paste at 120 degree C and 30 minutes is 0 to 0.50 GPa. Since the absolute value of the difference between the storage elastic modulus of the conductive pasted product of the present embodiment and the storage elastic modulus of the flexible base material at the temperature Tm is within the predetermined range, even when the electric wiring of the electric circuit and/or the electronic circuit is stretched and/or bent when forming the molded body, the deformations of the cured product of the flexible base material and the conductive paste are the same. Therefore, it is possible to form an electric wiring having a low possibility of breaking.

Also, since the conductive paste of the present embodiment is used for forming electric circuits such as electrodes and wirings of electric circuits and electronic circuits, it is necessary that the electric wiring obtained by using the conductive paste of the present embodiment has a low resistance value and is excellent in conductivity. By using the conductive paste of the present embodiment of a predetermined composition, it is possible to form an electric wiring having an appropriate specific resistance even when the electric wiring of the electric circuit and/or the electronic circuit is stretched and/or bent using three dimensional molding.

### <Molded body>

A molded body of the present embodiment can be produced by molding a flexible base material (a flexible electric circuit body) in which an electric circuit is formed. Specifically, for example, a molded body of the present embodiment can be produced by molding, such as three dimensional molding or injection molding, a flexible electric circuit body together with another resin (e.g., a flexible base material and a resin for molding, etc.). That is, the molded body of the present embodiment includes an electric circuit. The technology for producing a molded body including an electric circuit is called In-Mold Electronics. Therefore, the conductive paste of the present embodiment can be preferably used as a conductive paste for In-Mold Electronics.

A molding method for producing the molded body of the present embodiment is not particularly limited. The molding method for producing the molded body of the present embodiment can be exemplified as follows. For example, the molded body of the present embodiment can be produced by carrying out three dimensional molding of a flexible base material (a flexible electric circuit body) in which an electric circuit is formed. The molded body of the present embodiment can be produced by injection molding using a flexible base material (a flexible electric circuit body) in which an electric circuit is formed and a resin for molding. The molded body of the present embodiment can be produced by carrying out three dimensional molding of a flexible base material (flexible electric circuit body) in which an electric circuit is formed, and injection molding using a resin for molding.

The molded body of the present embodiment is preferably produced by three dimensional molding using heat molding. By heating a wiring pattern formed on the flexible electric circuit body using conductive paste of the present embodiment, it is possible to elongate and/or bend the wiring pattern. The flexible electric circuit body of the present embodiment including the electric circuit has flexibility. Therefore, the molded body of the present embodiment can be produced by forming a desired three dimensional shape using heat molding. Furthermore, if necessary, the molded body of a desired shape and design can be obtained by integrally forming the molded body of the three dimensional shape using a method such as injection molding.

In the method of manufacturing a molded body by In-Mold Electronics of a present embodiment, first, an electric circuit is formed on a surface of a flexible base material using the conductive paste of the present embodiment described above. Next, the flexible base material (a flexible electric circuit body) in which the electric circuit is formed is subjected to three dimensional molding or injection molding to form a molded body.

Specifically, an example of the process of manufacturing a molded body by In-Mold Electronics is as follows.

First, the conductive paste of the present embodiment described above is manufactured.

Next, the conductive paste of the present embodiment is printed on a surface of a flexible base material (for example, a flat sheet or a film made of polycarbonate resin) to form a print pattern (an electric circuit pattern).

Next, the print pattern of the conductive paste (the electric circuit pattern) printed on the flexible base material is heated and dried to cure, thereby producing a flexible electric circuit body. The curing conditions may be, for example, a heating temperature of 120 degree C and a heating time of 30 minutes.

Next, the flexible electric circuit body in which the electric circuit is formed is molded into a three dimensional shape by a molding method such as heat molding, pressure molding or vacuum molding. In the molding method such as heat molding, the heating temperature of the flexible electric circuit body is preferably 140 degree C to 220 degree C.

If necessary, the flexible electric circuit body in a three dimensional shape and a resin for molding are integrally molded by molding. For example, injection molding can be used as the molding method.

The molded body by In-Mold Electronics can be manufactured by the above process. According to the method for producing the molded body of the present embodiment, the molded body having the electric circuit with a low possibility of breaking can be produced by three dimensional molding.

### EXAMPLES

The present invention will be specifically described below with reference to Examples, but the present invention is not limited thereto.

### <Materials and Preparation Proportions of Conductive Pastes>

Table 1 and Table 2 show the compositions of the conductive pastes of Examples 1 to 13 and Comparative Examples 1 to 4. The compositions of the components described in Table 1 and Table 2 are "parts by weight" when the weight of the conductive particles is 100 parts by weight. The conductive pastes of the Examples and the Comparative Examples are conductive pastes consisting of silver particles (conductive particles), a thermoplastic resin and a solvent.

### <Conductive particles (A)>

The Examples and the Comparative Examples use silver particles as the conductive particles. Table 3 shows the manufacturer and model number, particle shape, average particle diameter (D50), tap (TAP) density, and BET specific surface area of silver particles A-D (conductive particles A-E) used in the Examples and the Comparative Examples. The tap density is the "bulk density" obtained after mechanical tapping of a container containing powder samples.

### <Thermoplastic resin (B)>

Table 4 shows manufacturer and model number, resin type, molecular weight, and glass transition temperature of resins A-F used in the Examples and the Comparative Examples as thermoplastic resins.

### <Solvent (C)>

Table 5 shows solvent type and boiling point of solvent A-C used in the Examples and the Comparative Examples. The thermoplastic resin described above was dissolved in the solvent and mixed with the conductive particles.

### <Preparation of Conductive Paste>

Next, a conductive paste was prepared by mixing the materials of the predetermined preparation ratio described above with a planetary mixer, dispersing them in a three-roll mill, and forming a paste.

### <Measurement method of viscosity>

The viscosity of the conductive pastes of the Examples and the Comparative Examples was measured by a Brookfield (type B) viscometer using an SC4-14 spindle (Utility Cup and Spindle (UC/S) = #14) at two rotational speeds of 10rpm and 1rpm, and at a measurement temperature of 25 degree C. Tables 1 and 2 show the measurement results of the viscosity of the conductive pastes at rotational speeds of 10 rpm and 1 rpm. The "Paste viscosity ratio" column of Tables 1 and 2 shows the ratio of the viscosity at rotational speed of 10 rpm to the viscosity at rotational speed of 1 rpm (the viscosity at rotational speed of 1 rpm / the viscosity at rotational speed of 10 rpm).

### <Measuring method of storage elastic modulus>

The storage elastic modulus of the cured products of the conductive pastes of the Examples and the Comparative Examples at a temperature (Tm) of 178 degree C was measured as follows.

First, a substrate of a slide glass on which a Teflon (registered trademark) tape was stuck was prepared. The conductive paste of the Examples and the Comparative Examples described above was printed on a surface of the Teflon (R) tape on a slide glass in such a size as to include a test pattern having a size of 40 mm in length and 5 mm in width. The thickness at which the conductive paste was printed was adjusted so that the thickness after curing was 200 ± 50 µm.

Next, the test pattern of the conductive paste was cured while the test pattern was arranged on the Teflon (registered trademark) tape on the slide glass. The curing conditions were 120 degree C for 30 minutes. That is, the substrate having the test pattern was left at 120 degree C for 30 minutes in an air atmosphere in an oven, and the conductive paste was dried to obtain a cured product of the test pattern.

Next, only the cured product of the test pattern (the cured product of coating film) was peeled off the Teflon (registered trademark) tape and taken out. The cured product was cut into a size of 40 mm in length and 5 mm in width to be a test piece. The thickness of the cured product was 200 µm ± 50 µm.

Next, the storage elastic modulus of the cured product of 40 mm in length, 5 mm in width, and 200 µm ± 50 µm in thickness was measured. The storage elastic modulus was measured using a Hitachi DMS7100 under the following conditions. The measurement temperature (Tm) was 178 degree C.
Measurement conditions: Amplitude: 5 µm, Tension: 1.2, Force: 0.05 N, Force Amplitude Default Value: 0.05 N

Table 1 and Table 2 show the measurement results of storage elastic modulus of the cured products of the conductive pastes of the Examples and the Comparative Examples at the temperature (Tm) of 178 degree C.

### <Measuring method of specific resistance before three dimensional molding>

The specific resistance of the cured products of the conductive pastes of the Examples and the Comparative Examples before three dimensional molding was measured as follows. As a flexible base material, a flat sheet (Film, Covestro Makrofol (registered trademark) DE 1-1 000000) of a material of a sheet-like flexible polycarbonate resin was used. The size of the base material was A4 size (210 mm × 297 mm) and the thickness was 250 µm. The base material was deformable (stretchable) at a temperature of about 160 degree C. A wiring pattern (length: 120 mm, width: 2 mm) of a conductive paste of the Examples and the Comparative Examples was printed on a surface of the base material. A screen printing machine was used for printing. After printing, the base material was cured by heating and drying at 120 degree C for 30 minutes in a constant temperature dryer. The obtained cured product of the wiring pattern (hereinafter, it is simply referred to as "wiring pattern".) had a film thickness of 10 to 20 µm. The film thickness was measured using a surface roughness profile measuring machine (model number: Surfcom 1500 SD-2) manufactured by Tokyo Seimitsu Co., Ltd.

The electrical resistance value (electrical resistance value before three dimensional molding) of the wiring pattern of the Examples and the Comparative Examples was measured by placing electrodes at both ends of a section with a distance of 80 mm near the center in the length direction and energizing the electrode. The electrical resistance value of the wiring pattern was measured by the 4 terminal method using a 7461 A digital multimeter manufactured by ADC. The specific resistance was calculated from the electrical resistance value and the dimensions of the wiring pattern.

The "Before molding" column of "Specific resistance" in Table 1 and Table 2 shows the specific resistance values before three dimensional molding calculated from the initial resistance values of the Examples and the Comparative Examples in exponential form. For example, the specific resistance "1.3E-4" before three dimensional molding in Example 1 in Table 1 indicates that the specific resistance was 1.3×10⁻⁴ Ω · cm. For Comparative Example 4, because the measured value was higher than the measurement limit (specific resistance: 5.0×10⁺³ Ω · cm) and measurement was not possible, it is listed as ">5E+3" in Table 1. The same applies to the specific resistance after molding described in the "After molding" column of "Specific resistance" in Table 1 and Table 2.

### <Measuring method of specific resistance after three dimensional molding>

The specific resistance after three dimensional molding of the cured products (the wiring patterns) of the conductive pastes of the Examples and the Comparative Examples was measured as follows. First, as described above, a flat sheet (Film, Covestro MakrofolR DE 1-1 000000) of a sheet-like flexible polycarbonate resin was used as a flexible base material. The size of the base material was A4 size (210 mm × 297 mm) and the thickness was 250 µm. The base material was deformable (stretchable) at a temperature of about 160 degree C. The wiring pattern shown in Fig. 3 was printed on a surface of the base material using the conductive paste of the Examples and the Comparative Examples. In the wiring pattern shown in Fig. 3, two patterns of 2 mm width and 120 mm length were separated by 56 mm. A screen printing machine was used for printing. After printing, a cured product was obtained by heating and drying at 120 degree C for 30 minutes in a constant temperature dryer. The cured product of the obtained wiring pattern (it is simply referred to as a "wiring pattern".) had a film thickness of 10 to 20 µm. The film thickness was measured using a surface roughness profile measuring machine (model number: Surfcom 1500 SD-2) manufactured by Tokyo Seimitsu Co., Ltd.

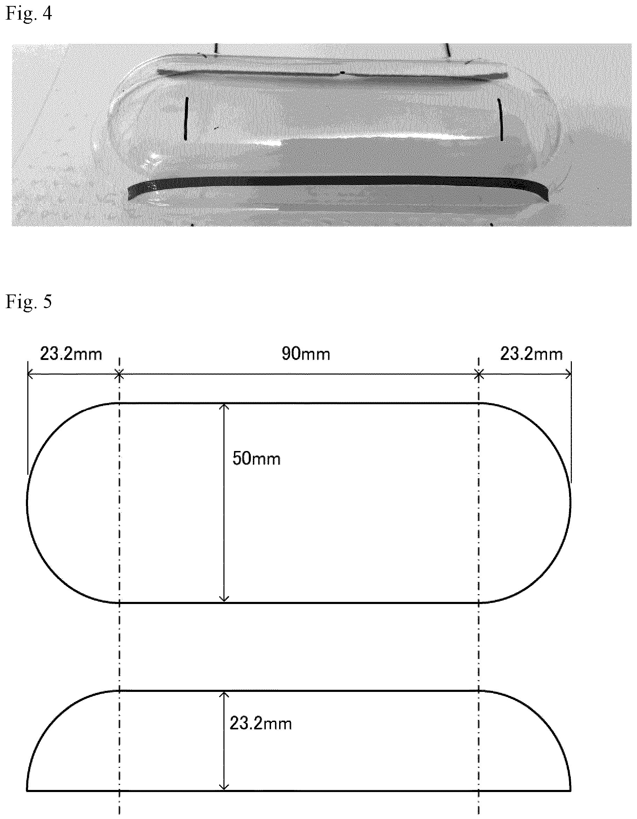

Next, the flat sheet (the flexible base material) on which the cured product of the wiring pattern of the Examples and the Comparative Examples was formed was subjected to three dimensional molding by heat molding. The heat molding was performed using a vacuum molding machine (model number: Formech 450 T). The conditions of heat molding were heater output of 100% and heating time of 11 seconds. After heating the flat sheet (the flexible base material) with a heater, the pattern was pressed and vacuumed to perform three dimensional molding. Fig. 4 shows an example of a shape after three dimensional molding. The wiring pattern of the cured product of the conductive paste was deformed by three dimensional molding to the shape shown in Fig. 4. Fig. 5 shows a schematic diagram of the shape after three dimensional molding. The upper part of Fig. 5 is a plan schematic diagram, and the lower part of Fig. 5 is a side schematic diagram. In Fig. 5, wiring after three dimensional molding is omitted.

Next, an electrical resistance value (an electrical resistance value after three dimensional molding) of the wiring pattern of the Examples and the Comparative Examples after three dimensional molding was measured by placing electrodes at both ends of the interval with a distance of 80 mm near the center in the length direction and energizing. The electrical resistance value of the wiring pattern was measured by the 4 terminal method using a 7461 A digital multimeter manufactured by ADC. The specific resistance was calculated from the electrical resistance value and the dimensions of the wiring pattern. The specific resistance values after three dimensional molding calculated from the resistance values after three dimensional molding of the Examples and the Comparative Examples are shown in the "After molding" column of "Specific resistance" in Table 1 and Table 2 in exponential form.

The change rate of specific resistance ((Resistivity after three dimensional molding / Resistivity before three dimensional molding) × 100 - 100) before and after three dimensional molding is shown in Table 1 and Table 2.

### <Measuring method of cracks>

The generation of cracks was measured for the wiring patterns of the Examples and the Comparative Examples after three dimensional molding, which were produced for measuring the specific resistance after three dimensional molding. Figs. 4 and 5 show photographs and shapes after three dimensional molding. As shown in Fig. 4 of the photograph after three dimensional molding, the wiring pattern was deformed by three dimensional molding. The center part and the end part of the wiring were deformed differently. The deformation by three dimensional molding in the center part of the wiring was a deformation in which the width extended about 60% in the width direction of the wiring (a deformation in which the width of 2 mm before molding became about 3.2 mm after molding). Compared with the center part of the wiring, the end part was elongated like an arc, and the deformation was complicated and large. Therefore, it was found that the generation of cracks was more frequent in the end part than in the center part of the wiring pattern. Therefore, the center part and the end part of the wiring pattern of the Examples and the Comparative Examples after three dimensional molding were observed at 20 times magnification using an optical microscope, and the occurrence of cracks was determined.

Fig. 1 shows an example of an optical microscope image (magnification: 20×) of a cured product (a wiring pattern) of a conductive paste subjected to three dimensional molding without cracking in the cured product. Fig. 2 shows an example of an optical microscope image (magnification: 20×) of a cured product (a wiring pattern) of a conductive paste subjected to three dimensional molding with cracking in the cured product. In the optical microscope image of the wiring pattern in Fig. 2, it can be seen that a stripe pattern is generated. This stripe pattern is caused by cracking. In contrast, no stripe pattern was observed in the optical microscope image of the wiring pattern in Fig. 1. Therefore, it can be determined that cracking is not generated in the wiring pattern in Fig. 1. Thus, the presence or absence of cracking was determined by observing the surface of the wiring pattern of the Examples and the Comparative Examples using an optical microscope (magnification: 20×).

Table 1 and Table 2 show the results of determining the presence or absence of cracking as described above for the center part and the end part of the wiring pattern of the Examples and the Comparative Examples. Tables 1 and 2 also show the results of determining the moldability of the wiring patterns in the Examples and the Comparative Examples during three dimensional molding based on the presence or absence of cracks at the center part and the end part of the wiring patterns observed by optical microscopy. "A" is a wiring pattern determined to have no cracks at both the center part and the end part, "B" is a wiring pattern determined to have no cracks at the center part but to have cracks at the end part, "C" is a wiring pattern determined to have cracks at part of the center part and cracks at the end part, and "D" is a wiring pattern determined to have cracks at both the center part and the end part. When the moldability is "A", the wiring pattern can preferably be used as a wiring after three dimensional molding. When the moldability is "B", the wiring pattern can preferably be used as a wiring after three dimensional molding in a specific application. When the moldability is "C" or "D", it is difficult to use the wiring after three dimensional molding even in a specific application. Here, the specific application is an application in which three dimensional molding is performed with deformation such that the elongation of the width of the wiring is about 40 to 70%, preferably 55 to 65%, and more preferably 50 to 60%, and the elongation of the wiring in the longitudinal direction is 20% or less, preferably 10% or less, and more preferably 5% or less. As described above, when the moldability is "B", the deformation in the center part of the wiring by three dimensional molding is a deformation in which the width extends about 60% in the width direction of the wiring, no cracks occur, and the wiring pattern can be used in such an application.

### <Measurement results of Examples and Comparative Examples>

As shown in Tables 1 and 2, the storage elastic modulus of the cured products at the temperature Tm (Tm = 178 degree C) obtained by curing the conductive pastes of the Examples 1 to 13 at 120 degree C for 30 minutes was in the range of 0.001 to 0.5 GPa. On the other hand, the storage elastic modulus of the cured products at the temperature Tm (Tm = 178 degree C) obtained by curing the conductive pastes of the Comparative Examples 1 to 4 at 120 degree C for 30 minutes was 0.51 GPa or higher (the Comparative Examples 1 to 3) or 0.00025 GPa (the Comparative Example 4). Therefore, the storage elastic modulus of the cured products, in which the conductive pastes of the Comparative Examples 1 to 4 were cured under the predetermined condition, was not in the range of 0.001 to 0.5 GPa.

As shown in Tables 1 and 2, the absolute values of the differences between the storage elastic modulus (0.002 GPa) at the temperature Tm (Tm = 178 degree C) of the flexible base material and the storage elastic modulus of the cured products at the temperature Tm (Tm = 178 degree C) obtained by curing the conductive pastes of the Examples 1 to 13 at 120 degree C for 30 minutes were in the range of 0.001 GPa (Example 5) to 0.488 GPa (the Example 11), which were in the range of 0.001 to 0.5 GPa.

As shown in Table 1, the cured products (the wiring patterns) obtained by curing the conductive pastes of the Comparative Examples 1 to 3 at 120 degree C for 30 minutes generated cracks at the edge parts after three dimensional molding. In addition, the center parts of the cured products (the wiring patterns) of the Comparative Examples 1 and 2 generated cracks, and a part of the center part of the cured product (the wiring pattern) of the Comparative Example 3 generated cracks. Therefore, the moldability evaluation of Comparative Examples 1 and 2 was "D", and the moldability evaluation of Comparative Example 3 was "C". Therefore, it became clear that it was difficult to use the cured products (the wiring patterns) of the conductive pastes of the Comparative Examples 1 to 3 as a wiring after three dimensional molding.

As shown in Table 1, the cured product (the wiring pattern) obtained by curing the conductive paste of the Comparative Example 4 at 120 degree C for 30 minutes did not generate cracks after three dimensional molding. However, because the specific resistance of the cured product (the wiring pattern) of the Comparative Example 4 was higher than the measurement limit (5.0×10⁺³ Ω · cm), it became clear that it was difficult to use as a wiring after three dimensional molding.

In contrast, the center part of the cured products (the wiring patterns) obtained by curing the conductive pastes of the Examples 1 to 13 at 120 degree C for 30 minutes did not generate cracks after three dimensional molding. Therefore, the moldability of the cured products (the wiring patterns) of the conductive pastes of the Examples 1 to 13 is "A" or "B". Therefore, it became clear that the cured products (the wiring patterns) of the conductive pastes of the Examples 1 to 13 could form electric wirings with a low possibility of breaking even when the electric wirings of electric circuits and/or electronic circuits were formed by using three dimensional molding.

In addition, the specific resistances of the cured products (the wiring patterns) of the conductive pastes of the Examples 1 to 13 before three dimensional molding were in the range from 7.0×10⁻⁵ Ω · cm (the Example 12) to 1.1×10⁺¹ Ω · cm (the Example 13). In addition, the specific resistances of the cured products (the wiring patterns) of the conductive pastes of the Examples 1 to 13 after three dimensional molding were in the range from 8.8×10⁻⁵ Ω · cm (the Example 12) to 1.0×10⁺¹ Ω · cm (the Example 13). Therefore, the cured products (the wiring patterns) of the conductive pastes of the Examples 1 to 13 were the values of the specific resistances that could be properly used as a wiring before and after three dimensional molding.

**[Table 1]**

| | | Comparative Example 1 | Comparative Example 2 | Comparative Example 3 | Example 1 | Example 2 | Example 3 | Example 4 | Example 5 | Comparative Example 4 |
|---|---|---|---|---|---|---|---|---|---|---|
| (A) Conductive particles | Particles A | 100 | 100 | 100 | 100 | 100 | 100 | 100 | 100 | 100 |
| | Particles B | | | | | | | | | |
| | Particles C | | | | | | | | | |
| | Particles D | | | | | | | | | |
| (B) Thermoplastic resin | Resin A | | | | | | | | | |
| | Resin B | 8.7 | 11.1 | 13.6 | 16.3 | 19.0 | 22.0 | 25.0 | 38.9 | 100.0 |
| | Resin C | | | | | | | | | |
| | Resin D | | | | | | | | | |
| | Resin E | | | | | | | | | |
| | Resin F | | | | | | | | | |
| (D) Solvent | Solvent A | 27.2 | 66.7 | 68.2 | 69.8 | 71.5 | 73.2 | 75.0 | 83.3 | 120.0 |
| | Solvent B | | | | | | | | | |
| | Solvent C | | | | | | | | | |
| Storage elastic modulus of cured product (GPa) | | 2.900 | 1.330 | 0.510 | 0.240 | 0.140 | 0.060 | 0.030 | 0.001 | 0.0002 5 |
| Difference in storage elastic modulus between base material and cured product (GPa) | | 2.898 | 1.328 | 0.508 | 0.238 | 0.138 | 0.058 | 0.028 | -0.001 | -0.002 |
| Paste viscosity (Pa·s) | Rotation speed 10rpm | 201.0 | 72.0 | 60.0 | 24.0 | 32.0 | 24.0 | 16.0 | 13.0 | 8.8 |
| | Rotation speed 1rpm | 570.0 | 150.0 | 130.0 | 60.0 | 70.0 | 53.8 | 46.3 | 32.0 | 24.0 |
| Paste viscosity ratio 1rpm/10rpm | | 2.8 | 2.1 | 2.2 | 2.5 | 2.2 | 2.2 | 2.9 | 2.5 | 2.7 |
| Specific resistance (Ω·cm) | Before molding | 1.8E-5 | 2.3E-5 | 4.5E-5 | 1.3E-4 | 1.6E-4 | 3.5E-4 | 6.5E-4 | 1.1E-2 | >5E+3 |
| | After molding | 2.4E-5 | 3.2E-5 | 3.2E-5 | 1.0E-4 | 1.4E-4 | 3.0E-4 | 2.4E-4 | 7.0E-3 | >5E+3 |
| Change rate of specific resistance | | 33.3 | 139.1 | 71.1 | 79.2 | 88.0 | 84.8 | 36.5 | 63.6 | - |
| Cracks (Center part) | | Yes | Yes | A part Yes | No | No | No | No | No | No |
| Cracks (End part) | | Yes | Yes | Yes | Yes | Yes | No | No | No | No |
| Moldability (Evaluation) | | D | D | C | B | B | A | A | A | A |

**[Table 2]**

| | | Example 6 | Example 7 | Example 8 | Example 9 | Example 9 | Example 10 | Example 11 | Example 12 | Example 13 |
|---|---|---|---|---|---|---|---|---|---|---|
| (A) Conductive particles | Particles A | | | | 100 | 100 | 100 | 100 | 100 | 100 |
| | Particles B | 100 | | | | | | | | |
| | Particles C | | 100 | | | | | | | |
| | Particles D | | | 100 | | | | | | |
| (B) Thermoplastic resin | Resin A | | | | 25.0 | 25.0 | | | | |
| | Resin B | 25.0 | 25.0 | 25.0 | | | | | | |
| | Resin C | | | | | | 25.0 | | | |
| | Resin D | | | | | | | 25.0 | | |
| | Resin E | | | | | | | | 25.0 | |
| | Resin F | | | | | | | | | 25.0 |
| (D) Solvent | Solvent A | 75.0 | 75.0 | 75.0 | 75.0 | | 75.0 | 75.0 | 75.0 | |
| | Solvent B | | | | | 75.0 | | | | |
| | Solvent C | | | | | | | | | 75.0 |
| Storage elastic modulus of cured product (GPa) | | 0.150 | 0.250 | 0.030 | 0.026 | 0.050 | 0.030 | 0.490 | 0.450 | 0.160 |
| Difference in storage elastic modulus between base material and cured product (GPa) | | 0.148 | 0.248 | 0.028 | 0.024 | 0.048 | 0.028 | 0.488 | 0.448 | 0.158 |
| Paste viscosity (Pa·s) | Rotation speed 10rpm | 19.8 | 9.9 | 76.1 | 15.0 | 25.0 | 25.0 | 10.8 | 8.1 | 286.0 |
| | Rotation speed 1rpm | 67.5 | 38.8 | 141.0 | 40.0 | 71.3 | 78.0 | 35.0 | 26.3 | 750.0 |
| Paste viscosity ratio 1rpm/10rpm | | 3.4 | 3.9 | 1.9 | 2.7 | 2.9 | 3.1 | 3.2 | 3.2 | 2.6 |
| Specific resistance (Ω**·**cm) | Before molding | 2.2E-4 | 6.5E-4 | 3.7E-4 | 4.2E-4 | 3.7E-4 | 8.3E-4 | 1.6E-4 | 7.0E-5 | 1.1E+1 |
| | After molding | 1.1E-3 | 3.5E-4 | 3.1E-4 | 6.7E-4 | 5.5E-4 | 4.3E-4 | 2.3E-4 | 8.8E-5 | 1.0E+1 |
| Change rate of specific resistance | | 476.8 | 53.6 | 82.8 | 158.6 | 148.6 | 51.8 | 141.1 | 125.4 | 90.9 |
| Cracks (Center part) | | No | No | No | No | No | No | No | No | No |
| Cracks (End part) | | No | No | No | Yes | Yes | No | Yes | Yes | No |
| Moldability (Evaluation) | | A | A | A | B | B | A | B | B | A |

**[Table 3]**

| Conductive particles | Model No. | Manufacturer | Particle Shape | Average particle diameter (D50) **(µm)** | TAP Density (g/cm³) | BET specific surface area (g/m²) |
|---|---|---|---|---|---|---|
| Conductive particles A | K-79136P | Metalow Technologies | Indefinite form | 0.98 | 2.3 | 1.9 |
| Conductive particles B | P903-2 | Metalow Technologies | Indefinite form | 1.24 | 1.63 | 2.83 |
| Conductive particles C | K-79121P | Metalow Technologies | Indefinite form | 0.81 | 2.77 | 2.59 |
| Conductive particles D | SF70A | AMES GOLDSMITH | Scale-like shape | 1.66 | 3.2 | 1.4 |

**]Table 4]**

| Resin | Model number | Manufacturing company | Type | Viscosity average molecular weight | Glass transition temperature (deg C) |
|---|---|---|---|---|---|
| Resin A | PCZ-200 | Mitsubishi Gas Chemicals | Poly (4, 4'-cyclohexylidenediphenyl) carbonate (High heat resistance polycarbonate) | 20,000 | 183.7 |
| Resin B | PCZ-500 | Mitsubishi Gas Chemicals | Poly (4, 4'-cyclohexylidenediphenyl) carbonate (High heat resistance polycarbonate) | 51,000 | 186.3 |
| Resin C | PCZ-800 | Mitsubishi Gas Chemistry | Poly (4, 4'-cyclohexylidenediphenyl) carbonate (High heat resistance polycarbonate) | 80,000 | 187.6 |
| Resin D | FPC-8225 | Mitsubishi Gas Chemicals | (Highly Soluble Polycarbonate) | 20,000 | 156 |
| Resin E | FPC-0330 | Mitsubishi Gas Chemicals | (Highly soluble polycarbonate) | 32,000 | 123 |
| Resin F | M1913 | Asahi Kasei | Maleic acid modified styrene-butadiene elastomer | - | 100 |

**]Table 5]**

| Resin | Type | Boiling Point (°C) |
|---|---|---|
| Solvent A | Isophorone | 215 |
| Solvent B | Ethyl Carbitol Acetate | 217 |
| Solvent C | Diethylene glycol dibutyl ether | 255 |

## Claims

1. A conductive paste for forming a flexible electric circuit for forming an electric circuit on a surface of a flexible base material, comprising:
conductive particles (A);
a thermoplastic resin (B); and
a solvent (C),
wherein a temperature Tm (degree C) for measuring storage elastic modulus of the conductive paste is Tm = 178 degree C; and
the storage elastic modulus at the temperature Tm of a cured product, in which the conductive paste is cured with a condition of 120 degree C for 30 minutes, is 0.001 to 0.5 GPa.

2. The conductive paste according to claim 1, wherein an absolute value of a difference between storage elastic modulus of the flexible base material at the temperature Tm and the storage elastic modulus of the cured product cured with the condition of 120 degree C for 30 minutes is 0 to 0.50 GPa.

3. The conductive paste according to claim 1 or 2, wherein the thermoplastic resin (B) comprises at least one selected from a group consisting of polycarbonate resin, hydrogenated styrene-based thermoplastic elastomer, and styrene-butadiene-styrene block copolymer.

4. The conductive paste according to claim 3, wherein the polycarbonate resin comprises at least one selected from poly (4, 4'-cyclohexylidenediphenyl) carbonate and copoly [2, 2-bis (4-hydroxyphenyl) propane/2, 2-bis (4-hydroxy-3-methylphenyl) propane] carbonate.

5. A conductive paste according to any one of claims 1 to 4, wherein the conductive particles (A) are silver particles.

6. A conductive paste according to any one of claims 1 to 5, wherein the conductive particles (A) are indefinite form or scale-like in shape.

7. A conductive paste according to any one of claims 1 to 6, wherein the flexible base material comprises at least one selected from a group consisting of polycarbonate, polyethylene terephthalate (PET) and acrylic resin.

8. An electric circuit comprising a cured product of the conductive paste according to any one of claims 1 to 7.

9. A flexible electric circuit body comprising the flexible base material and the electric circuit according to claim 8 disposed on a surface of the flexible base material.

10. A method for producing a molded body comprising:
forming an electric circuit on a surface of the flexible base material using the conductive paste according to any one of claims 1 to 7; and
forming the molded body by molding the flexible base material on which the electric circuit is formed.
